# EUROPEAN PATENT APPLICATION

(11) **EP 4 471 822 A1**
(43) Date of publication of application: **04.12.2024**
(21) Application number: 23202402.6
(22) Date of filing: 09.10.2023
(51) Int. Cl.: H01J 37/32

(54) **PLASMA TREATMENT APPARATUS**

(30) Priority: 02.06.2023 JP 2023091626
(71) Applicant: Plasma Ion Assist Co., Ltd., Kyoto-shi, Kyoto 612-8373 (JP)
(72) Inventor: WATANABE, Masanori, Katano-shi, Osaka, 576-0021 (JP); SUZUKI, Yasuo, Otsu-shi, Shiga, 520-0225 (JP)
(74) Representative: Müller Hoffmann & Partner

(57) **Abstract**

A plasma treatment apparatus is constituted by a treated base material at a ground potential in a plasma treatment chamber and an inductive coupling antenna unit disposed to face the base material, and a bias electrode which modulates a plasma potential is provided between them. In addition, an in-line type plasma treatment apparatus in which a plurality of the treatment chambers are connected is provided.

## Description

### CROSS-REFERENCE TO RELATED APPLICATION

This application claims the priority benefit of Japan application serial no. 2023-091626, filed on June 2, 2023. The entirety of the above-mentioned patent application is hereby incorporated by reference herein and made a part of this specification.

### BACKGROUND

### Technical Field

The disclosure relates to a plasma treatment apparatus capable of continuously performing a plurality of plasma treatment processes.

### Related Art

Patent Document 1 (Japanese Patent No. 5747231) discloses a plasma treatment apparatus having a plate-shaped high frequency antenna conductor attached to cover an opening portion formed in a wall surface of a vacuum container with airtightness, and configured to feed high frequency electric power to one end portion of the antenna conductor in a longitudinal direction, directly ground the other end portion to flow high frequency current thereto, generate plasma using an induced electromagnetic field generated in the vicinity of the antenna conductor, and perform plasma treatment on a substrate to be treated using the plasma. In addition, Patent Document 2 (Japanese Patent Application Laid-Open No. 2016-149287) discloses a plasma treatment apparatus in which two main and subsidiary antenna conductors are provided.

Plasma treatment processes of a substrate material by a plasma treatment apparatus include a plurality of plasma treatment processes such as a cleaning process of a substrate surface, an ion implantation process, a forming process of a diamond-like carbon (hereinafter, also referred to as DLC) film, and the like. In these processes, it is necessary to perform plasma treatment while a treated base material is irradiated with ions as negative potential for plasma potential of discharge plasma. In the plasma treatment apparatus disclosed in Patent Documents 1 and 2, ion irradiation is performed by applying a negative DC voltage or a negative pulse voltage for plasma potential to the treated base material.

However, for example, in the plasma treatment apparatus having a plurality of plasma treatment processes by a roll-to-roll method, since the base material and the conveyance system as a whole have the same negative potential, for example, if the treatment conditions for each plasma treatment chamber are changed, the configuration of the device becomes complicated, expensive, and impractical.

### SUMMARY

An embodiment of the disclosure provides a plasma treatment apparatus, including: a plasma treatment chamber (hereinafter, also simply referred to as a treatment chamber) in which a treated base material at a ground potential is accommodated, a conveyance part which conveys the treated base material in the plasma treatment chamber, an inductive coupling antenna unit (hereinafter, also simply referred to as an antenna unit) configured to generate plasma, and a bias electrode which applies a bias potential to the plasma, the bias electrode being disposed around a plasma generation region in which the plasma is generated.

Accordingly, the plasma potential of the discharge plasma generated by the antenna unit can be controlled, and simultaneously, a diffusion region of the discharge plasma can be suppressed.

Then, since the treated base material at the ground potential can be irradiated with ions by applying a bias potential to the plasma via the bias electrode, the plasma treatment can be performed on the surface of the object to be treated while holding the treated base material and the conveyance system at the ground potential.

Further, for example, the plurality of plasma treatment processes having different treatment conditions can be continuously performed by changing the bias potential applied to the bias electrode for each treatment chamber. Furthermore, it is effective in reducing the cost of the apparatus and improving safety by keeping the treated base material and the conveyance system at the ground potential.

The plasma treatment apparatus according to an embodiment of the disclosure includes a vacuum exhaust part configured to vacuum-exhaust the inside of the treatment chamber and a gas introduction part configured to introduce a working gas, and introduces the working gas according to the plasma treatment process.

According to the above-mentioned configuration, an appropriate gas pressure, for example, 1 Pa, in the treatment chamber can be adjusted by the gas introduction part.

In an embodiment, the bias electrode may be a structure that surrounds the plasma generation region.

According to the above-mentioned configuration, the object to be treated can be efficiently irradiated with the ions in the plasma.

In an embodiment, the antenna unit is a structure mounted to close the opening portion formed in the wall surface of the plasma treatment chamber, and constituted by a lid body in a rectangular shape and an inductive coupling antenna conductor (hereinafter, also simply referred to as an antenna conductor) attached to an inner side surface of the lid body via the feed-through fixed to the lid body.

According to the above-mentioned configuration, high density discharge plasma can be excited in the treatment chamber by supplying high frequency electric power to the antenna conductor.

In an embodiment, the lid body can be configured by an insulating plate of alumina or the like but may be constituted by a rectangular metal flange and a dielectric plate.

In an embodiment, the bias electrode is a frame body structure that surrounds the plasma generation region and is connected to a bias power supply.

According to the above-mentioned configuration, plasma treatment can be performed on the surface of the treated base material at the ground potential by applying a positive bias voltage to discharge plasma.

In an embodiment, the bias voltage is a DC voltage, a pulse voltage, or a pulsating current voltage obtained by half-wave rectifying an AC voltage according to plasma treatment content.

In an embodiment, the plurality of opening portions are formed in the wall surface of the treatment chamber substantially in parallel, and the antenna unit may be mounted in each of the opening portions.

According to the above-mentioned configuration, since the plurality of antenna units are each attached to separate opening portions, in comparison with the case in which the plurality of antenna conductors are attached to one opening portion, the size of the opening portion can be reduced. Accordingly, mechanical strength required for the lid body that closes each opening portion is reduced. It is possible to reduce manufacturing costs of the antenna unit.

In an embodiment, in an in-line type plasma treatment apparatus in which a plurality of the plasma treatment chambers are connected, front and rear sides of the plasma treatment chamber may be connected via a differential exhaust chamber connected to a differential exhaust system.

According to the above-mentioned configuration, the plurality of plasma treatment processes having different treatment conditions can be continuously performed, and effects according to the disclosure can be more significantly exhibited.

In the plasma treatment apparatus according to the embodiments of the disclosure, the treated base material can be held at the ground potential, and different plasma treatment can be achieved by changing the bias voltage applied to the bias electrode. In the case of one treatment chamber, the plurality of treatment processes can be executed sequentially in time, and when the plurality of treatment chambers are connected, the plurality of treatment processes according to the in-line type can be performed in parallel. In particular, in the roll-to-roll type plasma treatment apparatus having the plurality of treatment processes, different plasma treatment is possible for each treatment chamber. By locating both the treated base material and the conveyance system at the ground potential, the plasma treatment apparatus can be simplified, the manufacturing cost can be reduced, and the handling safety can be significantly improved.

That is, according to the plasma treatment apparatus of the embodiments of the disclosure, the plasma treatment can be performed while irradiating high energy ions by grounding the treated base material and applying the positive bias voltage to the bias electrode to perform positive potential plasma treatment without applying a high frequency voltage or a pulse voltage to the treated base material at the ground potential.

### BRIEF DESCRIPTION OF THE DRAWINGS

FIG. 1 is a schematic cross-sectional view showing an embodiment of a plasma treatment apparatus of the disclosure.
FIG. 2 is a schematic view showing an embodiment of a bias electrode of the disclosure.
FIG. 3 is a schematic view showing an embodiment of an antenna conductor.
FIG. 4 is a schematic view showing another embodiment of the antenna conductor.

### DESCRIPTION OF THE EMBODIMENTS

Embodiments of the disclosure provide an inexpensive and safe plasma treatment apparatus having a configuration that enables plasma treatment while holding a treated base material and a conveyance system at a ground potential, and capable of continuously performing a plurality of plasma treatment processes having different treatment conditions.

Hereinafter, an embodiment of a plasma treatment apparatus according to the disclosure will be described with reference to the accompanying drawings.

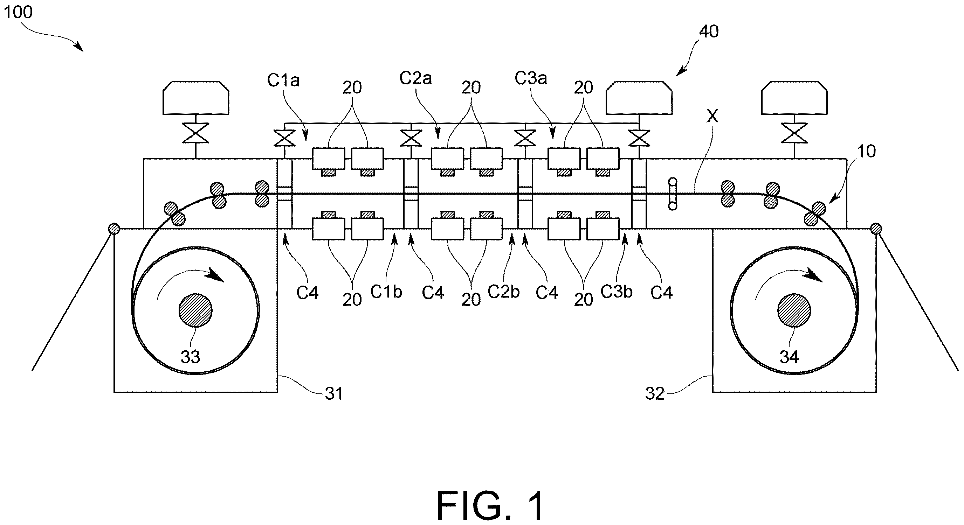

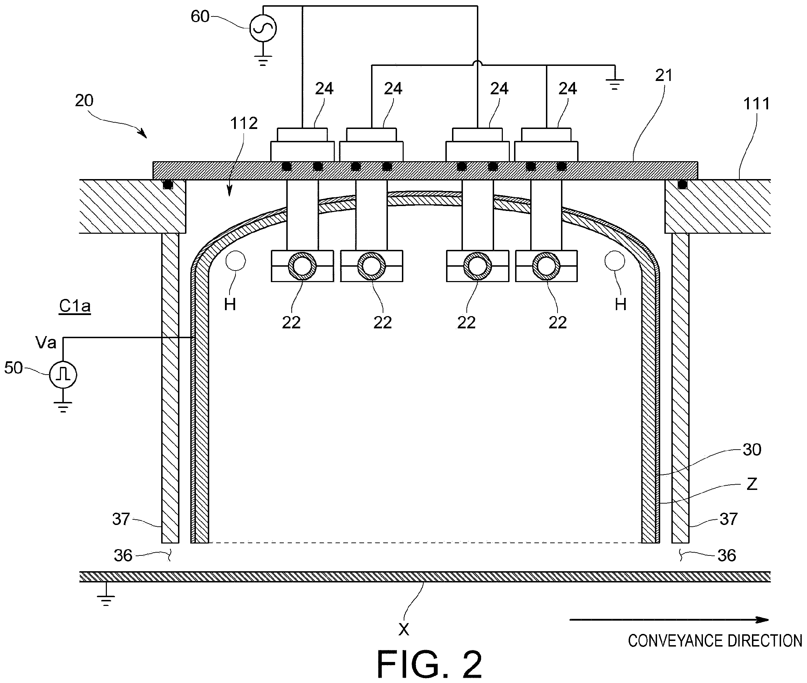

A configuration of a plasma treatment apparatus 100 of the embodiment is shown in FIG. 1. The plasma treatment apparatus 100 is a so-called roll-to-roll type plasma treatment apparatus in which a plurality of plasma treatment chambers C1, C2 and C3 can be connected to continuously perform a plurality of plasma treatment processes. For example, different plasma treatment can be simultaneously performed in parallel in each of the treatment chambers C1, C2 and C3 while a sheet-shaped treated base material X such as aluminum or the like is conveyed in the treatment chambers C1, C2 and C3 at a fixed speed. Further, while FIG. 1 shows the plasma treatment apparatus 100 having treatment chambers C1a, C2a and C3a disposed on a front surface side of the treated base material X and treatment chambers C1b, C2b and C3b disposed on a back surface side to perform plasma treatment on both surfaces of the treated base material X simultaneously, the treatment chambers may be disposed only on a single surface side of the treated base material X. Here, as a representative example for simplifying the description, a configuration of the treatment chamber C1a will be specifically described with reference to FIG. 2.

The plasma treatment apparatus 100 includes, as shown in FIG. 1 and FIG. 2, a conveyance part 10 configured to convey the treated base material X in the treatment chambers C1, C2 and C3 that are at a ground potential, an antenna unit 20 configured to generate plasma, and a bias electrode 30 configured to confine discharge plasma in a plasma generation region and apply a bias voltage to the plasma. Further, for convenience of description, illustration of the bias electrode 30 and a heating heater H is omitted in FIG. 1.

In addition, in the plasma treatment apparatus 100 of the embodiment, for example, a high frequency voltage of 13.56 MHz can be supplied to a central portion of an elongated antenna conductor 22 in a longitudinal direction to excite high density and high frequency discharge plasma in the vicinity of the antenna conductor 22, and a positive pulse voltage of, for example, 30 kHz or a low frequency AC voltage can be applied to the bias electrode 30 to perform plasma treatment on a surface of the treated base material X at a ground potential.

The plasma treatment apparatus 100 of the embodiment is a so-called inductive coupling plasma (ICP) type configured to generate discharge plasma using an electromagnetic field generated by flowing high frequency current to the inductive coupling antenna unit.

The bias electrode 30 is a frame body structure that surrounds a plasma generation region. The inside of the treatment chambers C1, C2 and C3 is held at a predetermined vacuum degree by a vacuum exhaust part 40 and a gas introduction part (not shown). For example, a mixed gas of argon and hydrogen is introduced from the gas introduction part and adjusted to a predetermined pressure, for example, 1 Pa. High frequency electric power is supplied to the antenna unit 20, and high density plasma is excited between the antenna unit 20 and the sheet-shaped base material X at the ground potential. The surface of the treated base material X can be cleaned by applying a bias voltage, for example, positive 2 kV to the bias electrode 30. In addition, in the embodiment, the heating heater H is disposed in the plasma generation region surrounded by the bias electrode 30.

In the plasma treatment apparatus 100 of the embodiment, the treated base material X is grounded, the discharge plasma is filled in a space (i.e., a plasma generation region) provided between the antenna unit 20 and the treated base material X, and the plasma potential is a potential of the treated base material X and walls of the treatment chambers C1, C2 and C3, i.e., the ground potential. In order to perform the plasma treatment on the treated base material X, a bias voltage of, for example, positive 2 kV is applied to the bias electrode 30 to make the plasma potential positive.

Opening portions 112 having a rectangular shape seen from above are formed in upper walls 111 of the treatment chambers C1, C2 and C3, and as shown in FIG. 2, the inside of the treatment chambers C1, C2 and C3 is closed by fitting the antenna unit 20, which will be described below, into the opening portion 112.

The antenna unit 20 is disposed to face the treated surface of the treated base material X conveyed in the treatment chambers C1, C2 and C3, and specifically, as shown in FIG. 2, and is a structure mounted to close the opening portions 112 formed in the wall surfaces of the treatment chambers C1, C2 and C3 and having a rectangular lid body 21 and the antenna conductor 22 attached to the lid body 21. The antenna conductor 22 is disposed on an inner side surface of the lid body 21 via a feed-through 24 fixed to the lid body 21.

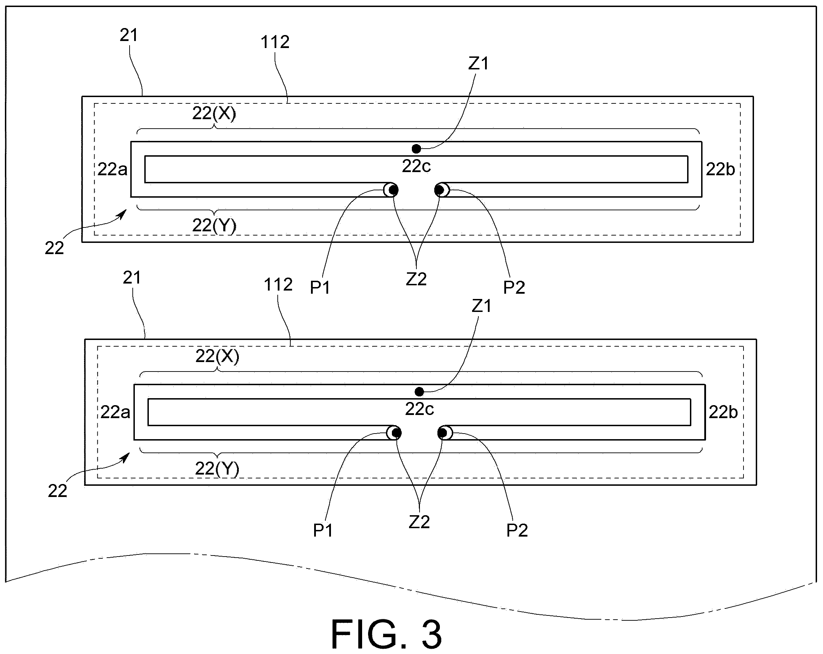

Further, in the embodiment, as shown in FIG. 3, in one or the plurality of treatment chambers C1, C2 and C3, the plurality of opening portions 112 are formed in the wall surface substantially in parallel, and the antenna unit 20 is mounted in each of the opening portions 112.

As shown in FIG. 2, the lid body 21 is constituted by a rectangular insulator plate provided along the opening portions 112 of the treatment chambers C1, C2 and C3, and in other words, constituted by only a single dielectric plate. However, the lid body 21 may be configured by integrating a rectangular metal flange provided along the opening portions 112 of the treatment chambers C1, C2 and C3 and a dielectric plate (insulator plate) supported by a metal flange thereof.

As shown in FIG. 3, the antenna conductor 22 is a rectangular frame body configured by bending a single metal pipe. A central portion of one (hereinafter, also referred to as the power-feed-side antenna conductor 22X) of long sides of the frame body (the antenna conductor 22) is connected to a power feed terminal Z1, and a central portion of the other (hereinafter, also referred to as the ground-side antenna conductor 22Y) is fixed and grounded to the lid body 21 via a vacuum seal member or the like.

In the embodiment, the U-shaped antenna conductor is disposed laterally symmetrically, and high frequency current supplied to a central portion 22c of the power-feed-side antenna conductor 22X flows leftward and rightward, U-turns at both end portions 22a and 22b, and flows to3ward a central portion of the ground-side antenna conductor 22Y. Accordingly, an orientation of the high frequency current flowing through the power-feed-side antenna conductor 22X is opposite to an orientation in which the high frequency current flows through the ground-side antenna conductor 22Y.

In the antenna conductor 22 configured in this way, the high frequency current supplied to the central portion 22c of the power-feed-side antenna conductor 22X in the longitudinal direction via the power feed terminal Z 1 flows toward both the left and right end portions 22a and 22b of the U-shaped antenna conductor 22, U-turns to flow through the ground-side antenna conductor 22Y in an opposite direction, and flows to a ground terminal Z2 of a central portion of the ground-side antenna conductor 22Y. Accordingly, an orientation of the high frequency current flowing through the power-feed-side antenna conductor 22X is opposite to an orientation in which the high frequency current flows through the ground-side antenna conductor 22Y.

That is, the antenna conductor 22 constitutes a round-trip circuit for the high frequency current supplied to the central portion 22c of the power-feed-side antenna conductor 22X in the longitudinal direction. In such a round-trip circuit, mutual inductance occurs between round-trip antenna conductors, and impedance of the antenna conductor with respect to the high frequency current is reduced by cancelling out the corresponding amount of the mutual inductance.

Since the impedance of the antenna conductor having such a configuration is reduced by canceling out the corresponding amount of the mutual inductance, an elongated antenna unit, for example, the antenna unit of 1 m or more can be put into practical use.

In addition, in the antenna unit 20 according to the disclosure, the power-feed-side antenna conductor 22X and the ground-side antenna conductor 22Y are disposed substantially in parallel along the inner side surface of the lid body 21, the high frequency currents flowing through both the antenna conductors 22X and 22Y are opposite to each other, and a maximum electromagnetic field is generated between both the antenna conductors 22X and 22Y. The inductive coupling antenna unit 20 has a configuration that can most effectively utilize the strong electromagnetic field and is most effective in generation of the high density plasma. In addition, discharge is likely to occur even in the low gas pressure region, and stable discharge plasma is maintained.

While the material of the antenna conductor 22 is not particularly limited, in order to supply high frequency electric power, for example, high frequency electric power of 13.56 MHz, in an embodiment, a metal material with good conductivity such as a copper material, an aluminum material, or the like, is preferable.

In addition, since the antenna conductor 22 is heated to several 100°C when high frequency current flows therethrough, in an embodiment, it is preferably a metal pipe capable of cooling such as water cooling or the like. According to the embodiment, since the central portion of the antenna conductor 22Y is grounded, cooling by water cooling is facilitated.

When a metal pipe such as a copper pipe, an aluminum pipe, or the like, is used as the antenna conductor 22, the pipe can be cooled by flowing coolant such as water therethrough. Specifically, as shown in FIG. 3, the entire antenna conductor 22 can be cooled by injecting the coolant from an inlet P1 of one side of the central portion of the ground-side antenna conductor 22Y to go around the antenna conductor 22 and discharging the coolant from an outlet P2 of the other side of the central portion of the ground-side antenna conductor 22Y.

In an embodiment, the insulator plate that constitutes the lid body 21 is preferably made of a workable material with excellent insulation and thermal resistance, and can be made of, for example, ceramics material such as an alumina material, silicon nitride, or the like. In addition, if the antenna conductor 22 can be sufficiently cooled, a PEEK material or a Teflon-based organic material with excellent thermal resistance can be used.

In the embodiment, the antenna conductor 22 is mounted in the treatment chambers C1, C2 and C3 and thus exposed to the discharge plasma. Accordingly, the surface of the antenna conductor 22 is sputtered by ion irradiation according to the treatment condition, and a metal that constitutes the antenna conductor 22 may be scattered as impurities. Here, in an embodiment, the surface of the antenna conductor 22 is preferably coated with a dielectric material, for example, a quartz tube or the like or blocked by a quartz plate in order to suppress pollution due to the sputtering.

While a bi-directional the U-shaped antenna conductor 22 has been described in the embodiment, it may be a high frequency antenna having a structure in which power is supplied to one end portion of the elongated antenna conductor in the longitudinal direction and the other end portion is grounded, or a high frequency antenna having a structure in which power is supplied to a central portion of the elongated antenna conductor in the longitudinal direction and both end portions are grounded.

Since this embodiment is characterized by the bias electrode 30, the bias electrode will be specifically described below.

As shown in FIG. 2, the bias electrode 30 is provided around the plasma generation region. Here, the bias electrode 30 is a dome-shaped or box-shaped (substantially rectangular parallelepiped) frame body structure that surrounds the plasma generation region and has an opening directed toward the treated base material X. The discharge plasma excited by the antenna unit 20 is diffused in the plasma generation region between the antenna unit 20 and the treated base material X but confined in the box-shaped bias electrode 30. Accordingly, diffusion of the discharge plasma in the treatment chambers C1, C2 and C3 can be suppressed. In mass production equipment in the related art, removal and cleaning of attachments to the surface of the equipment such as a vacuum container or the like, for example, DLC films or the like, were major issues, but there is an effect that the attachments associated with the plasma reaction can be significantly reduced by suppressing the diffusion of the discharge plasma into the treatment chambers C1, C2 and C3 as much as possible. Further, the shape of the bias electrode 30 is not necessarily limited to a dome shape or a box shape, and may be, for example, a cylindrical frame body shape.

In the embodiment, a surface area of the bias electrode 30 is equal to or greater than a surface area of the treated base material X at the ground potential, and the potential of the discharge plasma changes following the potential of the bias electrode 30 surrounding the plasma. As shown in FIG. 2, the bias electrode 30 is connected to a positive bias power supply 50. When a positive bias voltage Va is applied to the bias electrode 30, the potential of the discharge plasma becomes a substantially positive bias potential Va. An ion sheath of a potential difference Va is generated on the surface of the treated base material X at the ground potential. Cations are accelerated due to the potential difference of the ion sheath, and the plasma treatment can be performed on the surface of the treated base material X by the plasma containing high energy cations.

The bias voltage is not particularly limited and may be a pulsating current voltage obtained by half-wave rectifying a DC voltage, a pulse voltage, or an AC voltage according to plasma treatment contents. In the case of the pulse voltage and the pulsating current voltage, the frequency is preferably 1 kHz to 100 kHz, for example.

In the embodiment, in order to prevent discharge between the bias electrode 30 and its surroundings, such as an upper wall 111 of a vacuum chamber 11, sidewalls 37, and the like, an insulating member Z formed by, for example, anodized aluminum treatment or the like is provided on the outer surface of the bias electrode 30.

In the plasma treatment apparatus 100 of the embodiment, for example, a high frequency voltage of 13.56 MHz is supplied to a central portion of the antenna conductor 22 in the longitudinal direction to excite high density and high frequency discharge plasma in the vicinity of the antenna conductor 22, and the plasma potential can be increased higher than the ground potential by applying a positive pulse voltage of 30 kHz or a low frequency AC voltage to the bias electrode 30. Accordingly, the plasma treatment can be performed on the surface of the treated base material X while irradiating high energy ions.

Since a high frequency power supply 60 (see FIG. 2) excites the discharge plasma in the vicinity of the antenna conductor 22, a frequency thereof is not limited to 13.56 MHz. In an embodiment, a high frequency voltage of 300 kHz or higher as used herein is preferred. In addition, a bias power supply 50 is for controlling the potential of the high density plasma in the treatment chambers C1, C2 and C3 and is a power supply capable of supplying a positive bias voltage. In an embodiment, for example, preferably, it is possible to supply a positive pulse voltage, a positive AC voltage, or a pulsating current voltage obtained through half-wave rectification. Further, when the working gas pressure is several Pa or more, it is also possible to excite discharge plasma by only the pulse voltage or the low frequency AC voltage.

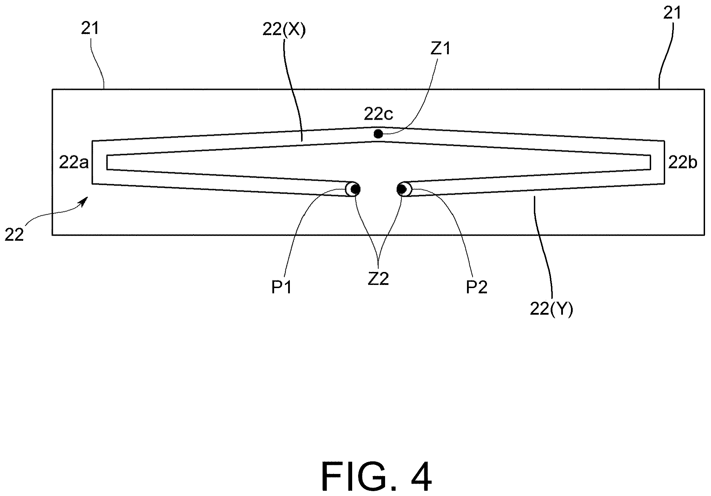

In addition, inductance of the parallel flat plate type U-shaped antenna conductor 22 is substantially proportional to a length of the U-shaped antenna conductor 22 and an interval between both the antenna conductors 22. That is, if both the antenna conductors 22 are brought close to each other, the inductance will be small, and if they are separated, the inductance will be large. In addition, as shown in FIG. 4, by increasing the interval between the central portions of the antenna conductors 22 and decreasing the interval of both end portions, the inductance of the central portion can be increased and the inductance of both end portions can be relatively decreased.

The impedance of the antenna unit 20 in the longitudinal direction can be changed by changing the interval between both the antenna conductors 22 at the arbitrary positions of the power-feed-side antenna conductor 22X and the ground-side antenna conductor 22Y in the longitudinal direction. When the high frequency current flows to the antenna conductor 22, high frequency electric power consumption is high in a high impedance part of the antenna conductor 22, and electromagnetic field energy is also high. Accordingly, a plasma density distribution of the plasma excited in the treatment chambers C1, C2 and C3 in the longitudinal direction of the antenna conductor 22 can be controlled, and a uniform plasma density distribution can be obtained.

According to the disclosure, it is possible to effectively heat the treated base material X or the like by disposing the heating heater H, which is a heating part, in the bias electrode 30. The radiant heat of the heating heater H can be utilized extremely effectively by using a metal plate with large thermal emissivity on an inner side and small thermal emissivity on an outer side as the material of the bias electrode 30. For example, an aluminum or aluminum alloy plate with a thermal emissivity of about 0.05 may be used.

For example, if an aluminum alloy plate with a thermal emissivity of about 0.05 is used, and the bias electrode 30 coated with a conductive black body material with a thermal emissivity of about 0.9, such as carbon black or the like, is used on the inner side surface, most of the radiant heat emitted from the heating heater H is consumed in heating the bias electrode 30 and the treated base material X. When the thermal emissivity inside the bias electrode 30 is increased, it is extremely effective in heating the treated base material X. Further, since the heat radiation loss from the outer side surface of the bias electrode 30 can be significantly suppressed, a temperature rise of the treatment chamber can also be significantly reduced.

An example of a roll-to-roll type (R to R type) according to the disclosure will be described with reference to FIG. 1. FIG. 1 is a schematic cross-sectional view showing the plasma treatment apparatus 100 from above and a conceptual view of an R to R type in-line plasma treatment apparatus in which the plurality of plasma treatment chambers C1, C2 and C3 are connected. A load chamber 31 and an unload chamber 32 are provided on left and right sides of the treatment chambers C1, C2 and C3 of the plasma treatment apparatus 100. The treated base material X is wound on a feed roll 33 and stored in the load chamber 31, sequentially conveyed into the treatment chambers C1, C2 and C3 by the conveyance part 10, and treated by a plasma treatment part. The treated base material X, which was treated, is wound and stored on a wind-up roll 34 stored in the unload chamber 32 by the conveyance part 10 and carried out to the outside as products periodically.

The in-line type plasma treatment apparatus 100 shown in FIG. 1 has the three treatment chambers C1, C2 and C3. For example, the surface of the base material X can be cleaned by ion irradiation in the first treatment chamber C1, formation of a thin film such as DLC or the like can be performed in the second treatment chamber C2, and, for example, functional surface treatment can be performed in the third treatment chamber C3. Of course, the plasma treatment apparatus 100 according to the disclosure may include a single treatment chamber.

The load chamber 31 and the unload chamber 32 are kept at high vacuum by an exhaust part. In addition, the insides of the treatment chambers C1, C2 and C3 are connected via a differential exhaust system 40. That is, the plasma treatment apparatus 100 is the in-line type plasma treatment apparatus in which the plurality of treatment chambers C1, C2 and C3 are connected, and front and rear sides of the treatment chambers C1, C2 and C3 are connected via a differential exhaust chamber C4 connected to the differential exhaust system 40. A working gas is introduced into each of the treatment chambers C1, C2 and C3 by a working gas introduction part (not shown), and a predetermined gas pressure is adjusted to, for example, 0.7 Pa. Further, the bias power supply 50 according to the plasma treatment process is provided for each of the treatment chambers C1, C2 and C3.

Further, in each treatment chamber, sizes of the treatment chambers C1, C2 and C3, the number of the antenna units 20 mounted, the size of the antenna conductor 21, and the like, can be designed arbitrarily according to plasma treatment contents.

When the plurality of plasma treatment processes is continuously performed in this way, the plurality of treatment chambers C1, C2 and C3 may be connected as shown in FIG. 1, and different plasma treatment can be performed for each of the treatment chambers C1, C2 and C3. That is, the plurality of types of plasma treatment can be simultaneously continuously performed by grounding the treated base material X, introducing a working gas necessary for each of the treatment chambers C1, C2 and C3 to adjust a gas pressure, and supplying different bias voltages for each of the treatment chambers C1, C2 and C3 to the bias electrode 30. Since the dedicated treatment chambers C1, C2 and C3 and the treatment condition can be set for each of the plasma treatment process, it is possible to achieve improvement of productivity and improvement of quality of products.

In the in-line type the plasma treatment apparatus 100 according to the disclosure, as shown in FIG. 2, conveyance of the treated base material X between the treatment chambers C1, C2 and C3 can be performed through a substrate conveyance slit 36 provided in a partition plate 37. Since each of the treatment chambers C1, C2 and C3 includes a working gas introduction part (not shown) and the vacuum exhaust part 40, a pressure difference of the working gas between the neighboring chambers C1, C2 and C3 can be controlled to several Pa or less. Accordingly, since the pressure difference of the working gas is several Pa or less and a gas conductance of the substrate conveyance slit 36 can be substantially reduced, mixing of working gases between the treatment chambers C1, C2 and C3 need not be considered.

In addition, when the plurality of plasma treatment processes having different treatment times is performed, it is difficult to convey the base material at a fixed speed. In this case, it is possible to employ an in-line type by intermittently conveying the base material.

It will be apparent to those skilled in the art that various modifications and variations can be made to the disclosed embodiments without departing from the scope or spirit of the disclosure. In view of the foregoing, it is intended that the disclosure covers modifications and variations provided that they fall within the scope of the following claims and their equivalents.

## Claims

1. A plasma treatment apparatus, comprising:
a plasma treatment chamber in which a treated base material at a ground potential is accommodated;
a conveyance part which conveys the treated base material in the plasma treatment chamber;
an inductive coupling antenna unit configured to generate plasma; and
a bias electrode which applies a bias voltage to the plasma,
wherein the bias electrode is disposed around a plasma generation region in which the plasma is generated.

2. The plasma treatment apparatus according to claim 1, wherein the bias electrode has a structure that surrounds the plasma generation region.

3. The plasma treatment apparatus according to claim 1, wherein the inductive coupling antenna unit has a structure mounted to close an opening portion formed in a wall surface of the plasma treatment chamber, and is constituted by a lid body in a rectangular shape and an inductive coupling antenna conductor attached to an inner side surface of the lid body.

4. The plasma treatment apparatus according to claim 3, wherein the lid body is constituted by a rectangular metal flange and a dielectric plate.

5. The plasma treatment apparatus according to claim 3, wherein the inductive coupling antenna conductor is installed on the inner side surface of the lid body via a feed-through fixed to the lid body.

6. The plasma treatment apparatus according to claim 3, wherein the inductive coupling antenna unit has a plurality of the inductive coupling antenna conductors installed on the inner side surface of the lid body.

7. The plasma treatment apparatus according to claim 1, wherein a plurality of opening portions are formed in a wall surface of the plasma treatment chamber substantially in parallel, and the inductive coupling antenna unit is mounted in each of the opening portions.

8. The plasma treatment apparatus according to claim 1, wherein the bias voltage applied to the bias electrode is a positive DC voltage, a positive pulse voltage, or a positive pulsating current voltage obtained through half-wave rectification of an AC voltage.

9. The plasma treatment apparatus according to claim 1, wherein a heating heater configured to heat the treated base material is provided in the bias electrode.

10. The plasma treatment apparatus according to claim 1, which is an in-line type plasma treatment apparatus in which a plurality of the plasma treatment chambers are connected, wherein front and rear sides of the plasma treatment chamber are connected via a differential exhaust chamber connected to a differential exhaust system.
